# EUROPEAN PATENT APPLICATION

(11) **EP 2 857 925 A1**
(43) Date of publication of application: **08.04.2015**
(21) Application number: 14186009.8
(22) Date of filing: 23.09.2014
(51) Int. Cl.: G06F 1/16, H04M 1/02

(54) **Hidden screw device and fastening method**

(30) Priority: 23.09.2013 CN 201310444573
(71) Applicant: Xiaomi Inc., Beijing 100085 (CN)
(72) Inventor: GAO, Yuan, Haidian District, Beijinq (CN); WU, Fenghui, Haidian District, Beijinq (CN); WANG, Jianyu, Haidian District, Beijinq (CN)
(74) Representative: Robson, Aidan John

(57) **Abstract**

The present disclosure discloses an invisible screw device, which belongs to the field of consumer electronics products. The device is mounted within a casing (114) and is used to fixedly connect the casing. The device includes a driving part (2), a screw (3), a nut (4)and a chip, the driving part is fixedly connected within one housing of the casing and the driving part is connected with the screw, while the nut is fixedly connected within the other housing of the casing, and the nut matches with the screw, the chip controls action of the driving part, and the driving part drives the screw to move relative to the nut, so as to achieve meshing or separation between the screw and the nut. The invisible screw structure is used in the device and method according to the present disclosure, which can achieve internal link and lock while no structure can be observed from the exterior; meanwhile, the device can be repeatedly assembled and disassembled without any part being replaced or scrapped; and the driving part is activated by the chip, which can prevent the device from being disassembled by non-professionals, so the safety may be improved.

## Description

### TECHNICAL FIELD

The present disclosure generally relates to the field of consumer electronic products, and more particularly, to an invisible screw device and a fastening method.

### BACKGROUND

Consumer electronic products mainly include digital cameras, mobile phones, Tablet PCs, home office equipments, etc. With the popularity of consumer electronic products, users have more and more strict requirements on appearances of products. Users often appreciate that the surfaces of products are clean, refined, seamless and have no extra or useless features. However, a screw, most commonly used as a fastening manner, will usually be observed by the user. For example, in Iphone 4, Iphone 5 or Samsung S4, a screw structure will be visible after the battery cover is disassembled. Such visible screw structures will badly affect the user's willingness to purchase.

In order to avoid extra structures from being observed by the users, the extra structures are usually hidden by adopting fastening methods. For example, in the design of Tablet PC, front housing assembly is connected with rear housing by structures such as screws and buckles, and then the display module is bonded to the front housing assembly by double sided adhesive tapes, so as to hide some unsightly structures, such as screws, etc. But the above mentioned connection scheme has the following defects:

Firstly, when being repaired, the display module can only be separated from the housing by hot air baking and sucker adsorption, which causes difficulties in repairing; secondly, the double sided adhesive tapes can be used only once, and they need to be scrapped and replaced after disassembly; thirdly, the users and non-professionals can freely disassemble the product, which will easily cause damages.

### SUMMARY

In order to solve the problems in the background art, such as difficulties in repairing, parts needed to be scrapped and replaced after disassembly, and damages easily caused, the embodiments of the present disclosure provide an invisible screw device and a fastening method. The technical solutions are as follows.

According to a first aspect of the present invention, there is provided an invisible screw device, which is mounted within a casing and is used to fixedly connect the casing, characterized in that, the device includes a driving part, a screw, a nut and a chip, the driving part is fixedly connected within one housing of the casing and the driving part is connected with the screw, while the nut is fixedly connected within the other housing of the casing, and the nut matches with the screw, the chip controls action of the driving part, and the driving part drives the screw to move relative to the nut, so as to achieve meshing or separation between the screw and the nut.

Preferably, the driving part is a servo motor.

Preferably, the casing includes a front housing and a rear housing, the driving part is fixedly connected within the front housing, and the nut is fixedly connected within the rear housing.

Preferably, the fixed connection between the driving part and one housing of the casing is bonding, screw connection or buckle connection.

Preferably, the fixed connection between the nut and the other housing of the casing is molding implantation, hot pressing or glue connection.

Preferably the device includes means to control the chip to activate the driving part such that the driving part drives the screw to move so as to achieve meshing or separation between the screw and the nut, and thereby to achieve connection or separation of the casing.

Preferably the device includes: means to receive a correct password via a product control interface from a user, and to control the chip to activate the driving part in response thereto.

The technical solutions provided by the embodiment of the present disclosure may bring about the following beneficial effects:

The invisible screw structure is used in the device and method according to the present disclosure, which can achieve internal link and lock while no structure can be observed from the exterior; meanwhile, the device can be repeatedly assembled and disassembled without any part being replaced or scrapped; and the driving part is activated by the chip, which can prevent the device from being disassembled by non-professionals, so the safety may be improved.

It should be understood that both the above general description and the following detailed description are only illustrative and explanatory, which do not limit the present disclosure.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.

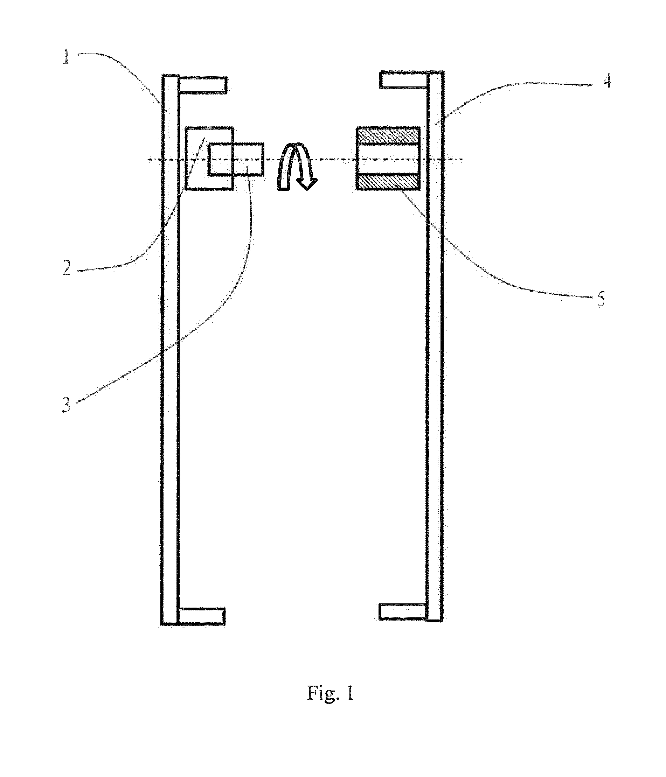

Fig. 1 is a structural diagram illustrating an invisible screw device provided by an embodiment of the present disclosure.

List of Reference Signs:
1 front housing; 2 driving part; 3 screw; 4 rear housing; 5 nut.

### DETAILED DESCRIPTION

In order to make purposes, technical solutions and advantages of the present disclosure more clear, hereinafter, the embodiments of the present disclosure will be further described in detail in conjunction with the drawings.

### The First Embodiment

As shown in Fig. 1, the embodiment of the present disclosure provides an invisible screw device. Mobile phones are taken as examples for illustrations in the present embodiment, the invisible screw device is mounted within a casing of a mobile phone, and the invisible screw device is used to fixedly connect housings 1 and 4. The invisible screw device includes a driving part 2, a screw 3, a nut 5 and a microprocessor chip (not illustrated). The driving part 2 is fixedly connected within one housing 1 or 4 of the casing and the driving part 2 is connected with the screw 3, while the nut 5 is fixedly connected within the other housing 4 or 1 of the casing, and the nut 5 matches with the screw 3. The chip (not illustrated) is used to control action of the driving part 2, and the driving part 2 drives the screw 3 to move relative to the nut 5, thereby the meshing or separation between the screw 3 and nut 5 can be achieved.

In one embodiment, after the driving part 2 is activated, the screw 3 can take the action of spinning in or out while making translational motions along an axis. The meshing or separation can be achieved after the screw 3 is aligned with the nut 5, which can achieve the connection or separation of the housings.

The structure of the invisible screw 3 is used in the device according to the present disclosure, which can achieve internal link and lock while no structure can be observed from the exterior; the device can be repeatedly assembled and disassembled without any part being replaced or scrapped; and the driving part 2 is activated by the chip, which can prevent the device from being disassembled by non-professionals, so that the safety may be improved.

In one embodiment, the driving part 2 is a servo motor. Alternatively, other motors can be selected.

In one embodiment, the casing includes a front housing 1 and a rear housing 4, the driving part 2 is fixedly connected within the front housing 1, and the nut 5 is fixedly connected within the rear housing 4.

In one embodiment, the fixed connection between the driving part 2 and one housing of the casing is bonding, screw connection or buckle connection. In this embodiment, the fixed connection between the driving part 2 and one housing of the casing is bonding.

In one embodiment, the fixed connection between the nut 5 and the other housing of the casing is molding implantation, hot pressing or glue connection. In this embodiment, the fixed connection between the nut 5 and the other housing of the casing is molding implantation.

Referring to Fig. 1, the embodiment provides a fastening method for the above-mentioned invisible screw device, and the fastening method is operated by the following steps.

In step 100, the driving part 2 is activated to act by the chip;

In step 200, the driving part 2 drives the screw 3 to move, thereby the meshing or separation between the screw 3 and the nut 5 can be achieved, and thus the connection or separation of the housings can be achieved.

The invisible screw structure is used in the device and method according to the present disclosure, which can achieve internal link and lock while no structure can be observed from the exterior; meanwhile, the device can be repeatedly assembled and disassembled without any part being replaced or scrapped; and the driving part 2 is activated by the chip, which can prevent the device from being disassembled by non-professionals, so the safety may be improved.

The method according to the present disclosure refers to all of technical solutions of the above mentioned device, so the invisible screw structure is used in the method, which can achieve internal link and lock while no structure can be observed from the exterior; meanwhile, the device can be repeatedly assembled and disassembled without any part being replaced or scrapped; and users can use means of confidentiality such as specifying passwords to prevent the device from being disassembled by non-professionals. In this embodiment, the internal link and lock, which are referred in particular to the fixed connection of two exterior components which are the front housing 1 and the rear housing 4, can be achieved by the inner structure of the device, and the connection strength is enough.

In one embodiment, the step 100 includes that the user may input a correct password via a product control interface, and then the driving part 2 is activated to act by the chip. By using the above mentioned method, users can use means of confidentiality such as specifying passwords to prevent the device from being disassembled by non-professionals, and the safety of products may be improved.

In one embodiment, the driving part 2 is a servo motor. Alternatively, other motors can be selected.

In one embodiment, the casing includes a front housing 1 and a rear housing 4, the driving part 2 is fixedly connected within the front housing 1, and the nut 5 is fixedly connected within the rear housing 4.

In one embodiment, the fixed connection between the driving part 2 and one housing of the casing is bonding, screw connection or buckle connection. In this embodiment, the fixed connection between the driving part 2 and one housing of the casing is bonding.

In one embodiment, the fixed connection between the nut 5 and the other housing of the casing is molding implantation, hot pressing or glue connection. In this embodiment, the fixed connection between the nut 5 and the other housing of the casing is molding implantation.

The serial numbers of the aforementioned embodiments in the present disclosure are only for illustrative purpose, not showing the superiority or inferiority of the embodiments.

The above contents are only preferred embodiments of the present disclosure, but are not intended to limit the present disclosure. Any modifications, equivalent replacements, improvements and the like are included in the scope of protection of the present disclosure.

## Claims

1. An invisible screw device, which is mounted within a casing (114) and is used to fixedly connect the casing, **characterized in** thatthe device comprises a driving part (2), a screw (3), a nut (4) and a microprocessor chip, the driving part (2?) is fixedly connected within one housing of the casing and the driving part is connected with the screw, while the nut is fixedly connected within the other housing of the casing, and the nut matches with the screw, the chip controls action of the driving part, and the driving part drives the screw to move relative to the nut, so as to achieve meshing or separation between the screw and the nut.

2. The device according to claim 1, **characterized in that**, the driving part is a servo motor.

3. The device according to claim 1, **characterized in that**, the casing comprises a front housing and a rear housing, the driving part is fixedly connected within the front housing, and the nut is fixedly connected within the rear housing.

4. The device according to claim 1, **characterized in that**, the fixed connection between the driving part and the one housing of the casing is bonding, screw connection or buckle connection.

5. The device according to claim 1, **characterized in that**, the fixed connection between the nut and the other housing of the casing is molding implantation, hot pressing or glue connection.

6. The device of claim 1, **characterized by**, means to control the chip to activate the chip such that the driving part, drives the screw to move so as to achieve meshing or separation between the screw and the nut, and thereby to achieve connection or separation of the casing.

7. The device according to claim 6, **characterized by**: means to receive a correct password via a product control interface from a user, and to control the chip to activate the driving part in response thereto.

8. A fastening method for use with the invisible screw device of any of claims 1 to 5, comprising:
activating, by a chip, a driving part to act; and
driving, by the driving part, a screw to move so as to achieve engagement or separation between the screw and a nut, thereby to achieve connection or separation of a first portion and a second portion of a housing.

9. The fastening method according to claim 6, wherein the activating comprises: inputting a correct password via a product control interface by a user, and activating the driving part to act by the chip.

10. The fastening method according to claim 6, wherein the driving part is a servo motor.

11. The fastening method according to claim 6, wherein further comprising:
the fixed connection between the driving part and the one housing of the casing is bonding, screw connection or buckle connection.

12. The fastening method according to any one of claims 1 to 9, wherein further comprising:
the fixed connection between the nut and the other housing of the casing is molding implantation, hot pressing or glue connection.

13. A terminal comprising an invisible screw device according to any of claims 1 to 5 and a memory for storing instructions executable by the processor;
a housing for enclosing the processor and the memory; and
a driving part is fixedly connected within one housing of the casing and a driving part is connected with a screw, while a nut is fixedly connected within the other housing of the casing, and the nut matches with the screw, a chip controls action of the driving part, and the driving part drives the screw to move relative to the nut, so as to achieve meshing or separation between the screw and the nut.
